# EUROPÄISCHE PATENTANMELDUNG

(11) **EP 4 297 083 A1**
(43) Veröffentlichungstag der Anmeldung: **27.12.2023**
(21) Anmeldenummer: 22179921.6
(22) Anmeldetag: 20.06.2022
(51) Int. Cl.: H01L 23/498

(54) **SCHALTUNGSANORDNUNG MIT ZWEI SCHALTUNGSTRÄGERN UND EINEM HALBLEITERBAUELEMENT**

(71) Anmelder: Siemens Aktiengesellschaft, 80333 München (DE)
(72) Erfinder: Bigl, Thomas, 91074 Herzogenaurach (DE); Pfefferlein, Stefan, 90562 Heroldsberg (DE); Hensler, Alexander, 91466 Gerhardshofen (DE); Müller, Bernd, 16259 Falkenberg (DE); Oschmann, Philipp, 91058 Erlangen (DE); Strogies, Jörg, 14163 Berlin (DE)
(74) Vertreter: Siemens Patent Attorneys

(57) **Zusammenfassung**

Die Erfindung betrifft eine Schaltungsanordnung (1) mit zwei Schaltungsträgern (3, 5) und einem zwischen den Schaltungsträgern (3, 5) angeordneten Halbleiterbauelement (7) mit zwei Lastanschlüssen (12, 13). Der erste Lastanschluss (12) weist eine dem ersten Schaltungsträger (3) zugewandte erste Lastanschlussfläche (15) auf, um die herum eine elektrisch isolierende Randabschlussstruktur (17) angeordnet ist. Der zweite Lastanschluss (13) weist eine dem zweiten Schaltungsträger (5) zugewandte zweite Lastanschlussfläche (16) auf, die größer als die erste Lastanschlussfläche (15) ist. Der erste Schaltungsträger (3) weist wenigstens eine erste Durchkontaktierung (34) auf, die die erste Lastanschlussfläche (15) mit wenigstens einer ersten Leiterbahn (37, 38) elektrisch verbindet, die im Innern des ersten Schaltungsträgers (3) oder auf einer dem Halbleiterbauelement (7) abgewandten Oberseite des ersten Schaltungsträgers (3) verläuft. Der zweite Schaltungsträger (5) weist eine dem Halbleiterbauelement (7) zugewandte Oberseite auf, die von einer ersten elektrisch leitfähigen Schicht (8) gebildet wird, die mit der zweiten Lastanschlussfläche (16) elektrisch verbunden ist.

## Beschreibung

Die Erfindung betrifft eine Schaltungsanordnung mit zwei Schaltungsträgern und mindestens einem Halbleiterbauelement. Das Halbleiterbauelement ist insbesondere ein Leistungshalbleiter.

Im Bereich der Leistungselektronik liegen Halbleiterbauelemente, beispielsweise Schaltelemente, in der Regel in Form von Leistungsmodulen, auch als Powermodule bezeichnet, oder in Form von diskreten Packages vor. Die Halbleiterbauelemente werden dabei meist mittels spezifischer Drahtbondtechnologien kontaktiert und die Leistungsmodule werden zum Beispiel mittels Löt-, Feder- oder Pressverbindungen an einem Schaltungsträger befestigt. Durch die Verwendung von Bonddrähten wird die maximal zulässige Stromdichte durch die Halbleiterbauelemente limitiert. Außerdem kommt es zu parasitären Induktivitäten, welche eine erzielbare Schaltgeschwindigkeit der Schaltelemente begrenzt.

WO 2020/249479 A1 offenbart einen elektronischen Schaltkreis, der unter anderem einen ersten Schaltungsträger, einen zweiten Schaltungsträger und ein leistungselektronisches Halbleiterbauelement aufweist. Das Halbleiterbauelement weist eine Oberseite auf, die an einer Unterseite des ersten Schaltungsträgers anliegt, sowie eine Unterseite, die an einer Oberseite des zweiten Schaltungsträgers anliegt. Der erste Schaltungsträger weist eine Durchkontaktierung (engl. Via) auf, welche die Oberseite des ersten Halbleiterbauelements elektrisch mit einer Leiterbahn des ersten Schaltungsträgers verbindet. Der zweite Schaltungsträger weist beispielsweise eine seine Oberseite bildende elektrisch leitfähige Schicht und eine, auf einer dem ersten Schaltungsträger abgewandten Seite der elektrisch leitfähigen Schicht angeordnete, elektrisch isolierende Schicht auf.

Der Erfindung liegt die Aufgabe zugrunde, eine verbesserte Schaltungsanordnung mit zwei Schaltungsträgern und mindestens einem Halbleiterbauelement anzugeben.

Die Aufgabe wird erfindungsgemäß durch eine Schaltungsanordnung mit den Merkmalen des Anspruchs 1 gelöst.

Vorteilhafte Ausgestaltungen der Erfindung sind Gegenstand der Unteransprüche.

Eine erfindungsgemäße Schaltungsanordnung umfasst
- einen mindestens zweilagigen ersten Schaltungsträger,
- einen zweiten Schaltungsträger und
- ein zwischen dem ersten Schaltungsträger und dem zweiten Schaltungsträger angeordnetes Halbleiterbauelement mit einem ersten Lastanschluss und einem zweiten Lastanschluss, wobei
- der erste Lastanschluss eine dem ersten Schaltungsträger zugewandte erste Lastanschlussfläche aufweist, um die herum eine elektrisch isolierende Randabschlussstruktur angeordnet ist,
- der zweite Lastanschluss eine dem zweiten Schaltungsträger zugewandte zweite Lastanschlussfläche aufweist, die größer als die erste Lastanschlussfläche ist,
- der erste Schaltungsträger auf einer dem Halbleiterbauelement zugewandten Unterseite ein erstes Lastanschlusskontaktpad aufweist, das elektrisch mit der ersten Lastanschlussfläche verbunden ist,
- der erste Schaltungsträger wenigstens eine erste Durchkontaktierung aufweist, die das erste Lastanschlusskontaktpad mit wenigstens einer ersten Leiterbahn verbindet, die im Innern des ersten Schaltungsträgers oder auf einer dem Halbleiterbauelement abgewandten Oberseite des ersten Schaltungsträgers verläuft, und
- der zweite Schaltungsträger eine dem Halbleiterbauelement zugewandte Oberseite aufweist, die von einer ersten elektrisch leitfähigen Schicht gebildet wird, die mit der zweiten Lastanschlussfläche elektrisch verbunden ist.

Die Begriffe "Oberseite" und "Unterseite" sind dabei nicht einschränkend zu verstehen, sondern orientieren sich an den Darstellungen in den Figuren. Ferner schließt die Formulierung, dass die Schaltungsanordnung ein Halbleiterbauelement aufweist, nicht aus, dass die Schaltungsanordnung mehrere Halbleiterbauelemente aufweist. Mithin weist die Schaltungsanordnung wenigstens ein Halbleiterbauelement mit den angegebenen Eigenschaften auf.

Das Halbleiterbauelement weist zwei Lastanschlüsse auf, die auf verschiedenen Seiten des Halbleiterbauelements angeordnet sind. Die Lastanschlüsse werden nicht über Bonddrähte kontaktiert, sondern der erste Lastanschluss wird durch das erste Lastanschlusskontaktpad des ersten Schaltungsträgers kontaktiert und der zweite Lastanschluss wird durch die erste elektrisch leitfähige Schicht des zweiten Schaltungsträgers kontaktiert (so genannte Flip-Chip-Technologie). Das erste Lastanschlusskontaktpad ist ferner durch wenigstens eine erste Durchkontaktierung mit wenigstens einer ersten Leiterbahn verbunden, die in einer Innenlage oder in einer dem Halbleiterbauelement abgewandten Außenlage des ersten Schaltungsträgers verläuft. Dadurch entfallen vorteilhaft bonddrahtbedingte Limitierungen der maximal zulässigen Stromdichte eines Stroms durch das Halbleiterbauelement und der Schaltgeschwindigkeit des Halbleiterbauelements. Das Halbleiterbauelement kann beispielsweise ein Transistor, ein Thyristor oder eine Diode sein.

Ein wesentliches Merkmal der erfindungsgemäßen Schaltungsanordnung ist ferner, dass der erste Lastanschluss dem ersten Schaltungsträger zugewandt ist und der zweite Lastanschluss dem zweiten Schaltungsträger zugewandt ist, wobei der erste Lastanschluss derjenige Lastanschluss ist, dessen Lastanschlussfläche von der Randabschlussstruktur umgeben ist. Die Randabschlussstruktur dient dazu, den Potentialunterschied zwischen den beiden Lastanschlüssen abzubauen.

Bei der aus dem Stand der Technik gemäß WO 2020/249479 A1 bekannten Anordnung ist dagegen der erste Lastanschluss dem zweiten Schaltungsträger zugewandt und elektrisch mit dessen erster elektrisch leitfähigen Schicht verbunden. Da an den Außenrändern der Randabschlussstruktur das Potential des zweiten Lastanschlusses anliegt, ist bei der aus dem Stand bekannten Anordnung ein hinreichender Abstand des ersten Lastanschlusses von dem zweiten Schaltungsträger erforderlich, da dessen großflächige erste elektrisch leitfähige Schicht auf dem Potential des ersten Lastanschlusses liegt. Der erforderliche Abstand hängt dabei von dem verwendeten Isolationsmaterial und der Sperrspannung des Halbleiterbauelements ab. Um diesen Abstand einzuhalten, werden beispielsweise Sinterpastendepots, Sinterpreforms oder Lötpreforms mit Abstandshalterfunktion verwendet und/oder die Randabschlussstruktur wird von der ersten elektrisch leitfähigen Schicht des zweiten Schaltungsträgers durch eine Passivierungsstruktur und/oder ein geeignetes Vergussmaterial elektrisch isoliert, das in einem aufwändigen, dem Vergussmaterial angepassten und auf das Vergussmaterial abgestimmten Vergießprozess vergosssen werden muss. Dieses Problem wird durch die erfindungsgemäße Anordnung zum einen dadurch behoben, dass der zweite Lastanschluss statt des ersten Lastanschlusses an dem zweiten Schaltungsträger angeordnet ist, und zum anderen dadurch, dass der erste Lastanschluss durch wenigstens eine erste Durchkontaktierung mit wenigstens einer Leiterbahn verbunden ist, die im Innern oder an der Oberseite des ersten Schaltungsträgers verläuft, wodurch das Substrat (Basismaterial) des ersten Schaltungsträgers eine zusätzliche Isolationsschicht zwischen jeder dieser Leiterbahnen und der Randabschlussstruktur des Halbleiterbauelements bereitstellt. Gegenüber der aus WO 2020/249479 A1 bekannten Anordnung vereinfacht dies die Herstellung der Schaltungsanordnung und ermöglicht eine kompaktere Form der Schaltungsanordnung, da die Abstände des Halbleiterbauelements von den Schaltungsträgern verringert werden können.

Bei einer Ausgestaltung der Erfindung ist das erste Lastanschlusskontaktpad vollständig innerhalb eines Bereiches der Unterseite des ersten Schaltungsträgers angeordnet, der zu einem von der Randabschlussstruktur umgebenen Bereich des Halbleiterbauelements korrespondiert. Mit dem Bereich der Unterseite des ersten Schaltungsträgers, der zu dem von der Randabschlussstruktur umgebenen Bereich des Halbleiterbauelements korrespondiert, wird dabei ein Bereich der Unterseite des ersten Schaltungsträgers bezeichnet, auf den der von der Randabschlussstruktur umgebene Bereich des Halbleiterbauelements durch eine Parallelverschiebung entlang einer zu einem Normalenvektor der Unterseite des ersten Schaltungsträgers parallelen Geraden abgebildet wird. Der zu dem von der Randabschlussstruktur umgebenen Bereich des Halbleiterbauelements korrespondierende Bereich der Unterseite des ersten Schaltungsträgers liegt dem von der Randabschlussstruktur umgebenen Bereich des Halbleiterbauelements somit direkt gegenüber und hat dieselbe Fläche und Form wie der von der Randabschlussstruktur umgebene Bereich des Halbleiterbauelements.

Die vorgenannte Ausgestaltung der Erfindung verhindert, dass sich Bereiche der Randabschlussstruktur und des ersten Lastanschlusskontaktpads direkt gegenüberliegen, und beabstandet somit vorteilhaft auf dem Potential des zweiten Lastanschlusses liegende Bereiche der Randabschlussstruktur von dem auf dem Potential des ersten Lastanschlusses liegenden ersten Lastanschlusskontaktpad.

Bei einer weiteren Ausgestaltung der Erfindung verläuft wenigstens eine erste Durchkontaktierung parallel zu einer ersten Geraden, die einen nicht verschwindenden Winkel mit einem Normalenvektor der Unterseite des ersten Schaltungsträgers bildet.

Bei einer weiteren Ausgestaltung der Erfindung ist das erste Lastanschlusskontaktpad durch wenigstens eine erste Durchkontaktierung mit wenigstens einer im Innern des ersten Schaltungsträgers verlaufenden ersten Leiterbahn verbunden, und diese Leiterbahn ist durch wenigstens eine weitere Durchkontaktierung, ein sogenanntes Blind-Via, mit wenigstens einer auf der Oberseite des ersten Schaltungsträgers verlaufenden Leiterbahn verbunden.

Die beiden vorgenannten Ausgestaltungen der Erfindung ermöglichen durch schräg verlaufende erste Durchkontaktierungen und/oder Blind-Vias eine Entzerrung der Anschlüsse und Leiterbahnen auf der Oberseite des ersten Schaltungsträgers. Dadurch können vorteilhaft erforderliche Spannungsabstände, Luft- und Kriechstrecken auf der Oberseite des ersten Schaltungsträgers eingehalten werden und die Schaltungsanordnung kann weiter kompaktiert werden, wodurch insbesondere Material eingespart werden kann.

Bei einer weiteren Ausgestaltung der Erfindung weist das Halbleiterbauelement einen Steueranschluss mit einer dem ersten Schaltungsträger zugewandten Steueranschlussfläche auf, die innerhalb des von der Randabschlussstruktur umgebenen Bereichs des Halbleiterbauelements angeordnet ist. Ferner weist der erste Schaltungsträger auf seiner Unterseite ein Steueranschlusskontaktpad auf, das elektrisch mit der Steueranschlussfläche verbunden ist. Des Weiteren weist der erste Schaltungsträger wenigstens eine zweite Durchkontaktierung auf, die das Steueranschlusskontaktpad mit wenigstens einer zweiten Leiterbahn verbindet, die im Innern des ersten Schaltungsträgers oder auf der Oberseite des ersten Schaltungsträgers verläuft.

Bei einer weiteren Ausgestaltung der Erfindung ist auch das Steueranschlusskontaktpad vollständig innerhalb des Bereichs der Unterseite des ersten Schaltungsträgers angeordnet, der zu dem von der Randabschlussstruktur umgebenen Bereich des Halbleiterbauelements korrespondiert.

Die beiden vorgenannten Ausgestaltungen der Erfindung betreffen eine Schaltungsanordnung mit wenigstens einem Halbleiterbauelement, das über einen Steueranschluss (engl. Gate) steuerbar ist. Derartige Halbleiterbauelemente sind beispielsweise Transistoren und Thyristoren. Diese Ausgestaltungen der Erfindung sehen eine Kontaktierung des Steueranschlusses vor, die analog zu der Kontaktierung des ersten Lastanschlusses mit den oben genannten Vorteilen ist.

Bei einer weiteren Ausgestaltung der Erfindung erstreckt sich das Steueranschlusskontaktpad in einen Bereich der Unterseite des ersten Schaltungsträgers hinein, der zu der ersten Lastanschlussfläche korrespondiert. Analog zu den obigen Ausführungen bezeichnet der Bereich der Unterseite des ersten Schaltungsträgers, der zu der ersten Lastanschlussfläche korrespondiert, einen Bereich der Unterseite des ersten Schaltungsträgers, auf den die erste Lastanschlussfläche durch eine Parallelverschiebung entlang einer zu einem Normalenvektor der Unterseite des ersten Schaltungsträgers parallelen Geraden abgebildet wird.

Die vorgenannte Ausgestaltung der Erfindung berücksichtigt, dass der Steueranschluss eines Halbleiterbauelements oft sehr klein ausgeführt ist. In einem solchen Fall bietet es sich an, dass Steueranschlusskontaktpad ausreichend groß auszubilden, so dass es in einen Bereich der Unterseite des ersten Schaltungsträgers hineinragt, der zu der ersten Lastanschlussfläche korrespondiert. Dadurch wird auch erreicht, dass bei Bestückversatz immer ausreichend Überlappung beziehungsweise Überdeckung zwischen dem Steueranschlusskontaktpad und der Steueranschlussfläche gegeben ist und der Steueranschluss somit sicher kontaktiert werden kann. Das erste Lastanschlusskontaktpad wird bei einer derartigen Ausbildung des Steueranschlusskontaktpads entsprechend kleiner ausgeführt.

Bei einer weiteren Ausgestaltung der Erfindung weist ein Abschnitt des Steueranschlusskontaktpads, der sich in den zu der ersten Lastanschlussfläche korrespondierenden Bereich der Unterseite des ersten Schaltungsträgers hinein erstreckt, zumindest einen nicht kontaktierbaren Bereich auf.

Bei einer weiteren Ausgestaltung der Erfindung weist ein zwischen dem Steueranschlusskontaktpad und dem ersten Lastanschlusskontaktpad liegender Bereich der Unterseite des ersten Schaltungsträgers einen nicht kontaktierbaren Bereich auf.

Die beiden vorgenannten Ausgestaltungen der Erfindung verhindern durch die nicht kontaktierbaren Bereiche vorteilhaft einen undefinierten Verbindungsmittelabfluss zwischen dem Steueranschlusskontaktpad und dem ersten Lastanschlusskontaktpad und die Gefahr eines Kurzschlusses zwischen dem Steueranschlusskontaktpad und dem ersten Lastanschlusskontaktpad oder der ersten Lastanschlussfläche. Ein nicht kontaktierbarer Bereich wird beispielsweise durch Beschichten mit einem Zusatzmaterial wie Lötstopplack, lokale Beeinflussung der Benetzungsfähigkeit beispielsweise durch Laseroxidation oder Abtrag vorhandenen Materials beispielsweise durch Stufenätzung erzeugt.

Bei einer weiteren Ausgestaltung der Erfindung verläuft jede zweite Durchkontaktierung parallel zu einer ersten Durchkontaktierung. Insbesondere können alle ersten und zweiten Durchkontaktierungen parallel zueinander verlaufen. Dies vereinfacht die Herstellung und Anordnung der ersten und zweiten Durchkontaktierungen und verhindert ein Kreuzen dieser Durchkontaktierungen.

Bei einer weiteren Ausgestaltung der Erfindung weist der zweite Schaltungsträger eine dem Halbleiterbauelement abgewandte Unterseite, die von einer zweiten elektrisch leitfähigen Schicht gebildet wird, und eine zwischen der ersten elektrisch leitfähigen Schicht und der zweiten elektrisch leitfähigen Schicht angeordnete elektrisch isolierende Isolationsschicht auf. Die Isolationsschicht ermöglicht vorteilhaft eine elektrische Isolierung der Unterseite des zweiten Schaltungsträgers von dessen Oberseite. Insbesondere ermöglicht dies eine Isolation gegenüber einem an der Unterseite angeordneten Kühlkörper. Ein solcher Kühlkörper wird häufig zur Entwärmung der Schaltungsanordnung eingesetzt. Durch die zweite elektrisch leitfähige Schicht kann insbesondere eine erhöhte Robustheit des zweiten Schaltungsträgers gegenüber thermischen Verformungen erzielt werden.

Bei einer weiteren Ausgestaltung der Erfindung weist der erste Schaltungsträger auf seiner Unterseite ein zweites Lastanschlusskontaktpad auf, das elektrisch mit der ersten elektrisch leitfähigen Schicht des zweiten Schaltungsträgers verbunden ist.

Bei einer weiteren Ausgestaltung der Erfindung weist der erste Schaltungsträger wenigstens eine dritte Durchkontaktierung auf, die das zweite Lastanschlusskontaktpad mit wenigstens einer dritten Leiterbahn verbindet, die im Innern des ersten Schaltungsträgers oder auf der Oberseite des ersten Schaltungsträgers verläuft.

Die beiden vorgenannten Ausgestaltungen der Erfindung ermöglichen, dem ersten Schaltungsträger das Potential des zweiten Lastanschlusses zuzuführen und den zweiten Lastanschluss mit wenigstens einer Leiterbahn des ersten Schaltungsträgers zu verbinden.

Bei einer weiteren Ausgestaltung der Erfindung verläuft wenigstens eine dritte Durchkontaktierung parallel zu einer zweiten Geraden, die einen nicht verschwindenden Winkel mit einem Normalenvektor der Unterseite des ersten Schaltungsträgers bildet, so dass ein Abstand jeder dritten Durchkontaktierung von jeder ersten Durchkontaktierung in einer zur Unterseite des ersten Schaltungsträgers parallelen Ebene mit dem Abstand dieser Ebene von der Unterseite des ersten Schaltungsträgers zunimmt. Auch diese Ausgestaltung der Erfindung ermöglicht durch schräg verlaufende dritte Durchkontaktierungen eine Entzerrung der Anschlüsse und Leiterbahnen auf der Oberseite des ersten Schaltungsträgers, um erforderliche Spannungsabstände, Luft- und Kriechstrecken auf der Oberseite des ersten Schaltungsträgers einzuhalten und die Schaltungsanordnung weiter zu kompaktieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine erste schematische Schnittdarstellung eines ersten Ausführungsbeispiels einer Schaltungsanordnung,
- FIG 2: eine zweite schematische Schnittdarstellung der in Figur 1 gezeigten Schaltungsanordnung,
- FIG 3: eine schematische Schnittdarstellung eines zweiten Ausführungsbeispiels einer Schaltungsanordnung,
- FIG 4: eine schematische Schnittdarstellung eines dritten Ausführungsbeispiels einer Schaltungsanordnung,
- FIG 5: eine schematische Schnittdarstellung eines vierten Ausführungsbeispiels einer Schaltungsanordnung,
- FIG 6: eine schematische Schnittdarstellung eines fünften Ausführungsbeispiels einer Schaltungsanordnung,
- FIG 7: eine schematische Schnittdarstellung eines sechsten Ausführungsbeispiels einer Schaltungsanordnung,
- FIG 8: eine schematische Schnittdarstellung eines siebten Ausführungsbeispiels einer Schaltungsanordnung,
- FIG 9: eine schematische Schnittdarstellung eines achten Ausführungsbeispiels einer Schaltungsanordnung,
- FIG 10: eine schematische Schnittdarstellung eines neunten Ausführungsbeispiels einer Schaltungsanordnung.

Einander entsprechende Teile sind in den Figuren mit denselben Bezugszeichen versehen.

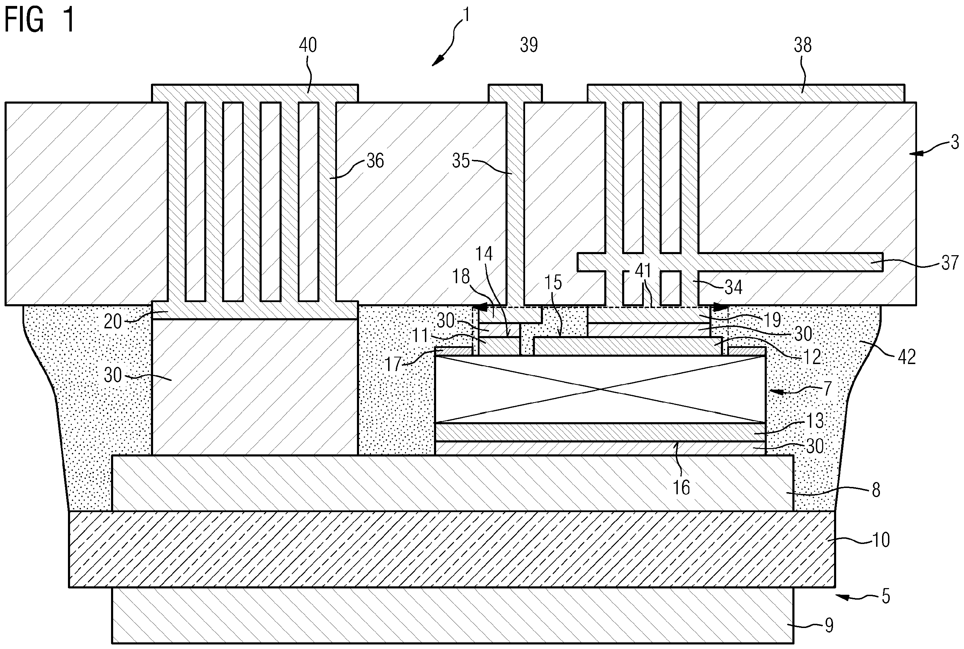

Figur 1 (FIG 1) zeigt eine erste schematische Schnittdarstellung eines ersten Ausführungsbeispiels einer Schaltungsanordnung 1. Die Schaltungsanordnung 1 umfasst einen ersten Schaltungsträger 3, einen zweiten Schaltungsträger 5 und ein zwischen dem ersten Schaltungsträger 3 und dem zweiten Schaltungsträger 5 angeordnetes Halbleiterbauelement 7.

Bei diesem Ausführungsbeispiel ist der erste Schaltungsträger 3 eine mehrlagige Leiterplatte. Der zweite Schaltungsträger 5 weist eine erste elektrisch leitfähige Schicht 8, eine zweite elektrisch leitfähige Schicht 9 und eine zwischen den beiden elektrisch leitfähigen Schichten 8, 9 angeordnete elektrisch isolierende Isolationsschicht 10 auf. Die erste elektrisch leitfähige Schicht 8 bildet eine dem Halbleiterbauelement 7 zugewandte Oberseite des zweiten Schaltungsträgers 5. Die zweite elektrisch leitfähige Schicht 9 bildet eine dem Halbleiterbauelement 7 abgewandte Unterseite des zweiten Schaltungsträgers 5. Die Isolationsschicht 10 ist beispielsweise eine Keramikschicht, die beispielsweise aus Aluminiumoxid, Aluminiumnitrid oder Siliziumnitrid gefertigt ist. Beispielsweise ist der zweite Schaltungsträger 5 ein DCB-Substrat (DCB: Abkürzung für Direct Copper Bonded) oder ein AMB-Substrat (AMB: Abkürzung für Active Metal Brazing).

Das Halbleiterbauelement 7 ist bei diesem Ausführungsbeispiel ein Transistor mit einem Steueranschluss 11, einem ersten Lastanschluss 12 und einem zweiten Lastanschluss 13. Beispielsweise ist der Transistor ein Bipolartransistor oder ein Bipolartransistor mit isolierter Gate-Elektrode (engl. Insulated-Gate Bipolar Transistor, abgekürzt IGBT), dessen erster Lastanschluss 12 ein Emitter-Anschluss ist und dessen zweiter Lastanschluss 13 ein Kollektor-Anschluss ist. Alternativ ist der Transistor beispielsweise ein Feldeffekttransistor, insbesondere ein Metall-Oxid-Halbleiter-Feldeffekttransistor (engl. Metal-Oxide-Semiconductor Field-Effect Transistor, abgekürzt MOSFET), dessen erster Lastanschluss 12 ein Source-Anschluss ist und dessen zweiter Lastanschluss 13 ein Drain-Anschluss ist. Bei anderen Ausführungsbeispielen kann das Halbleiterbauelement 7 statt eines Transistors beispielsweise ein Thyristor oder eine Diode sein. Im Fall, dass das Halbleiterbauelement 7 eine Diode ist, entfallen jedoch der Steueranschluss 11 und die mit ihm verbundenen Komponenten der Schaltungsanordnung 1.

Der Steueranschluss 11 weist eine dem ersten Schaltungsträger 3 zugewandte Steueranschlussfläche 14 auf. Der erste Lastanschluss 12 weist eine dem ersten Schaltungsträger zugewandte erste Lastanschlussfläche 15 auf. Der zweite Lastanschluss 13 weist eine dem zweiten Schaltungsträger 5 zugewandte zweite Lastanschlussfläche 16 auf, die größer als die erste Lastanschlussfläche 15 ist. Um die Steueranschlussfläche 14 und die erste Lastanschlussfläche 15 herum ist eine elektrisch isolierende Randabschlussstruktur 17 angeordnet, die einen Potentialunterschied zwischen den beiden Lastanschlüssen 12, 13 abbaut.

Der erste Schaltungsträger 3 weist auf einer dem Halbleiterbauelement 7 zugewandten Unterseite ein Steueranschlusskontaktpad 18, ein erstes Lastanschlusskontaktpad 19 und ein zweites Lastanschlusskontaktpad 20 auf. Das Steueranschlusskontaktpad 18 ist elektrisch mit der Steueranschlussfläche 14 verbunden. Das erste Lastanschlusskontaktpad 19 ist elektrisch mit der ersten Lastanschlussfläche 15 verbunden. Das zweite Lastanschlusskontaktpad 20 und die zweite Lastanschlussfläche 16 sind jeweils elektrisch mit der ersten elektrisch leitfähigen Schicht 8 des zweiten Schaltungsträgers 5 verbunden. Die elektrischen Verbindungen zwischen diesen Komponenten werden jeweils durch ein Verbindungsmaterial 30, beispielsweise ein Lot- oder Sintermaterial, hergestellt, das zwei Komponenten elektrisch verbindet. Das Verbindungsmaterial kann von den verbundenen Komponenten abhängen, wird der Einfachheit halber aber für alle diese elektrischen Verbindungen in den Figuren mit demselben Bezugszeichen 30 bezeichnet.

Der erste Schaltungsträger 3 weist mehrere Durchkontaktierungen 34, 35, 36 auf, die jeweils das erste Lastanschlusskontaktpad 19, das Steueranschlusskontaktpad 18 oder das zweite Lastanschlusskontaktpad 20 mit wenigstens einer Leiterbahn 37 bis 40 verbinden, die im Innern, das heißt in einer Innenlage des ersten Schaltungsträgers 3 oder auf einer dem Halbleiterbauelement 7 abgewandten Oberseite, das heißt in einer oberseitigen Außenlage des ersten Schaltungsträgers 3 verlaufen. In Figur 1 sind mehrere erste Durchkontaktierungen 34 gezeigt, die das erste Lastanschlusskontaktpad 19 mit einer Leiterbahn 37, die im Innern des ersten Schaltungsträgers 3 verläuft, und mit einer ersten Leiterbahn 38, die auf der Oberseite des ersten Schaltungsträgers 3 verläuft, verbinden. Ferner zeigt Figur 1 eine zweite Durchkontaktierung 35, die das Steueranschlusskontaktpad 18 mit einer zweiten auf der Oberseite des ersten Schaltungsträgers 3 verlaufenden Leiterbahn 39 verbindet, und mehrere dritte Durchkontaktierungen 36, die jeweils das zweite Lastanschlusskontaktpad 20 mit einer dritten auf der Oberseite des ersten Schaltungsträgers 3 verlaufenden Leiterbahn 40 verbinden.

Das Steueranschlusskontaktpad 18 und das erste Lastanschlusskontaktpad 19 sind vollständig innerhalb eines Bereiches 41 der Unterseite des ersten Schaltungsträgers 3 angeordnet, der zu einem von der Randabschlussstruktur 17 umgebenen Bereich des Halbleiterbauelements 7 korrespondiert.

Ein verbleibender Raumbereich zwischen der Unterseite des ersten Schaltungsträgers 3 und dem zweiten Schaltungsträger 5 ist durch ein Vergussmaterial 42, beispielsweise durch ein Gießharz, gefüllt.

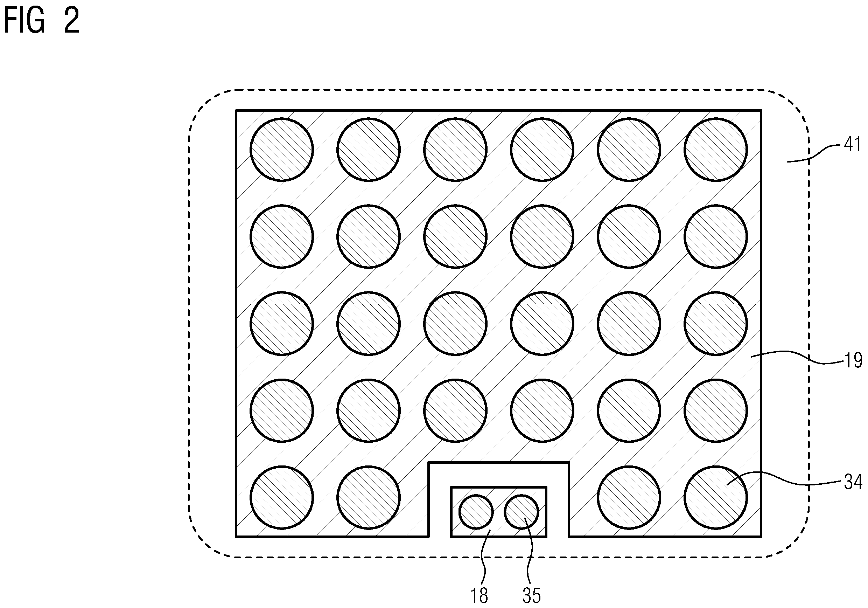

Figur 2 (FIG 2) zeigt eine zweite schematische Schnittdarstellung der in Figur 1 gezeigten Schaltungsanordnung 1 in dem Bereich 41 der Unterseite des ersten Schaltungsträgers 3, der zu dem von der Randabschlussstruktur 17 umgebenen Bereich des Halbleiterbauelements 7 korrespondiert. Figur 2 zeigt, dass das Steueranschlusskontaktpad 18 an drei Seiten von dem ersten Lastanschlusskontaktpad 19 umgeben ist, die kontaktpadseitigen Enden der ersten Durchkontaktierungen 34 ein zweidimensionales Array auf dem ersten Lastanschlusskontaktpad 19 bilden und das Steueranschlusskontaktpad 18 mit mehr als nur einer zweiten Durchkontaktierung 35 verbunden sein kann. Bei anderen Ausführungsbeispielen kann das Steueranschlusskontaktpad 18 auch vierseitig von dem Lastanschlusskontaktpad 19 umgeben sein, das heißt von dem Lastanschlusskontaktpad 19 eingerahmt sein. Ferner zeigt Figur 2, dass das erste Lastanschlusskontaktpad 19 und das Steueranschlusskontaktpad 18 vollständig in dem Bereich 41 angeordnet sind und dass daher auch die kontaktpadseitigen Enden der ersten Durchkontaktierungen 34 und der zweiten Durchkontaktierungen 35 vollständig in dem Bereich 41 liegen.

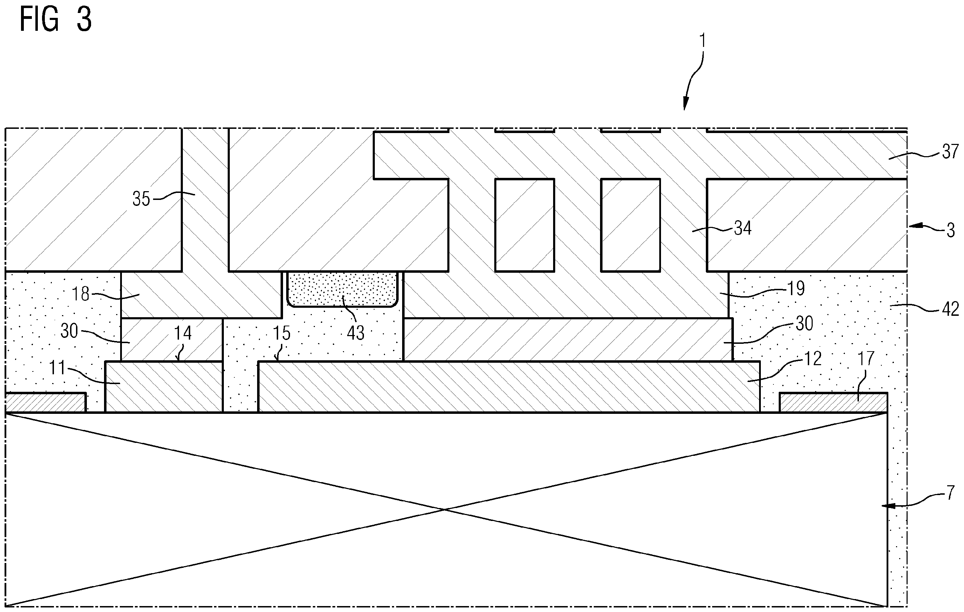

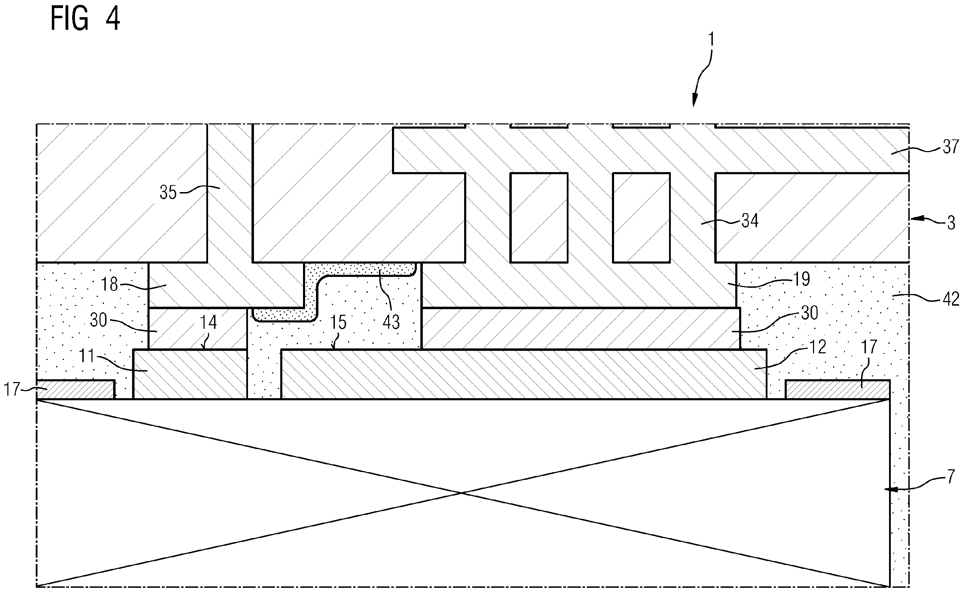

Figur 3 (FIG 3) zeigt eine schematische Schnittdarstellung eines zweiten Ausführungsbeispiels einer Schaltungsanordnung 1. Dieses Ausführungsbeispiel unterscheidet sich von dem in Figur 1 gezeigten Ausführungsbeispiel lediglich dadurch, dass ein zwischen dem Steueranschlusskontaktpad 18 und dem ersten Lastanschlusskontaktpad 19 liegender Bereich der Unterseite des ersten Schaltungsträgers 3 einen nicht kontaktierbaren Bereich 43 aufweist, der beispielsweise durch Lötstopplack gebildet wird. Daher zeigt Figur 3 nur einen Bereich der Schaltungsanordnung 1, der diesen Bereich der Unterseite des ersten Schaltungsträgers 3 umfasst. Dieses Ausführungsbeispiel berücksichtigt, dass sich das Steueranschlusskontaktpad 18 in einen Bereich der Unterseite des ersten Schaltungsträgers 3 hinein erstreckt, der zu der ersten Lastanschlussfläche 15 korrespondiert. Die Erstreckung des Steueranschlusskontaktpads 18 in den Bereich der Unterseite des ersten Schaltungsträgers 3, der zu der ersten Lastanschlussfläche 15 korrespondiert, vergrößert vorteilhaft die Größe des Steueranschlusskontaktpads 18 und ermöglicht dadurch eine sichere elektrische Kontaktierung des Steueranschlusskontaktpads 18 mit dem Steueranschluss 11 und den zweiten Durchkontaktierungen 35. Der nicht kontaktierbare Bereich 43 verhindert einen undefinierten Verbindungsmittelabfluss zwischen dem Steueranschlusskontaktpad 18 und dem ersten Lastanschlusskontaktpad 19 und die Gefahr eines Kurzschlusses zwischen dem Steueranschlusskontaktpad 18 und dem ersten Lastanschlusskontaktpad 19. Statt des Aufbringens von Lötstopplack kann die Benetzungsfähigkeit für das Verbindungsmittel 30 in dem zwischen dem Steueranschlusskontaktpad 18 und dem ersten Lastanschlusskontaktpad 19 liegenden Bereich der Unterseite des ersten Schaltungsträgers 3 durch eine lokale Zusatzbehandlung, beispielsweise durch Laseroxidation oder Stufenätzung, gesenkt werden (Entsprechendes trifft für die in den Figuren 3 und 4 gezeigten Ausführungsbeispiele zu).

Figur 4 (FIG 4) zeigt eine schematische Schnittdarstellung eines dritten Ausführungsbeispiels einer Schaltungsanordnung 1 analog zu Figur 3. Dieses Ausführungsbeispiel unterscheidet sich von dem in Figur 3 gezeigten Ausführungsbeispiel lediglich dadurch, dass der nicht kontaktierbare Bereich 43 auch einen dem ersten Lastanschlusskontaktpad 19 und der ersten Lastanschlussfläche 15 zugewandten Bereich des Steueranschlusskontaktpads 18 umfasst, um auch die Gefahr eines Kurzschlusses zwischen dem Steueranschlusskontaktpad 18 und der ersten Lastanschlussfläche 15 zu verhindern.

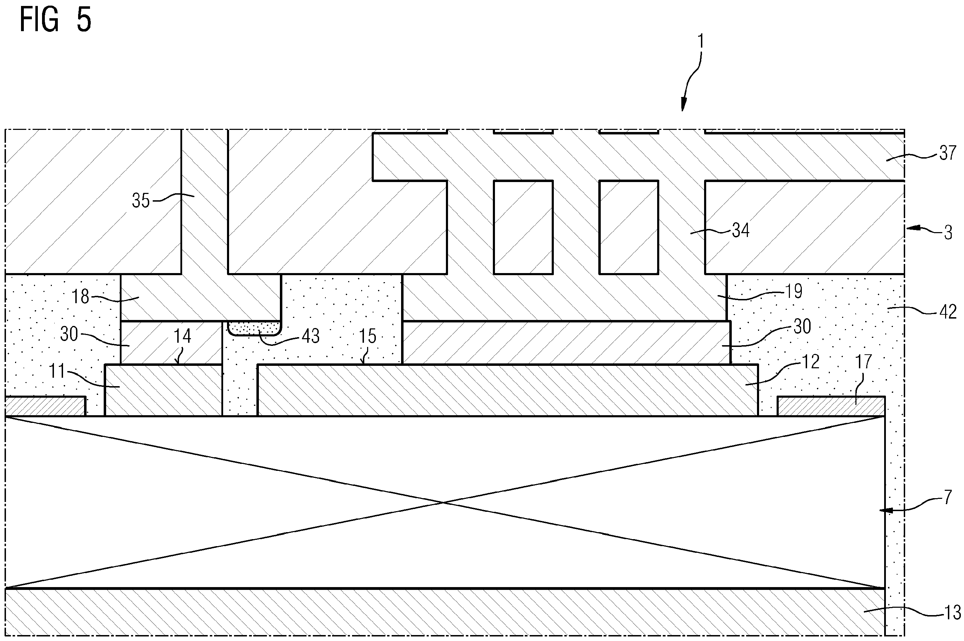

Figur 5 (FIG 5) zeigt eine schematische Schnittdarstellung eines vierten Ausführungsbeispiels einer Schaltungsanordnung 1 analog zu den Figuren 3 und 4. Dieses Ausführungsbeispiel unterscheidet sich von dem in den Figuren 3 und 4 gezeigten Ausführungsbeispielen lediglich dadurch, dass der nicht kontaktierbare Bereich 43 nur ein der ersten Lastanschlussfläche 15 zugewandter Bereich des Steueranschlusskontaktpads 18 ist, um die Gefahr eines Kurzschlusses zwischen dem Steueranschlusskontaktpad 18 und der ersten Lastanschlussfläche 15 zu verhindern.

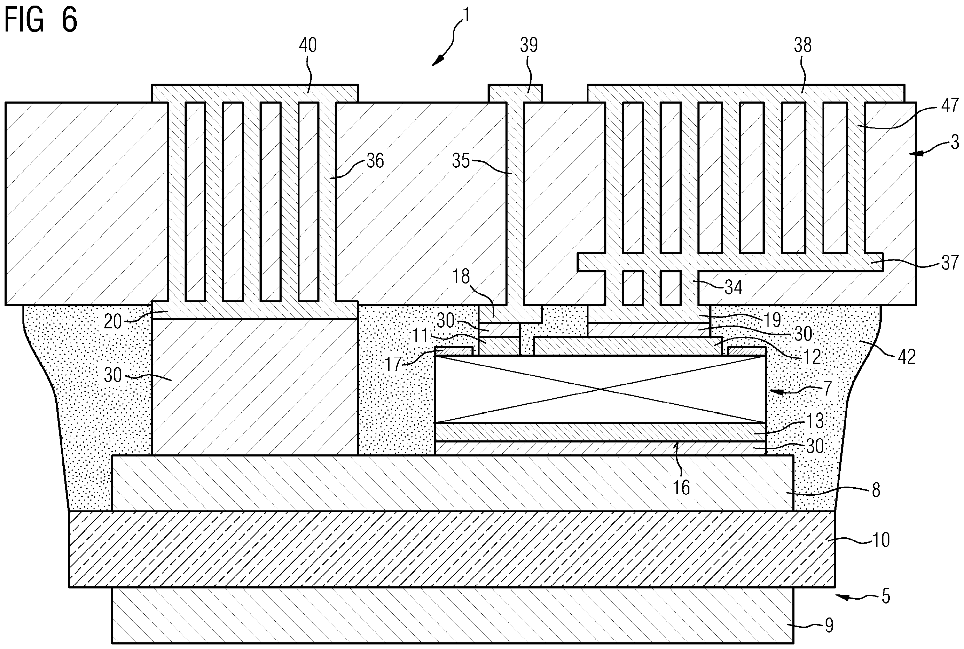

Figur 6 (FIG 6) zeigt eine schematische Schnittdarstellung eines fünften Ausführungsbeispiels einer Schaltungsanordnung 1. Dieses Ausführungsbeispiel unterscheidet sich von dem in Figur 1 gezeigten Ausführungsbeispiel lediglich dadurch, dass im Inneren des ersten Schaltungsträgers 3 verlaufende Leiterbahnen 37 und auf der Oberseite des ersten Schaltungsträgers 3 verlaufende Leiterbahnen 38 durch zusätzliche Durchkontaktierungen 47 (Blind-Vias) verbunden sind, die Stromdichten von Strömen zwischen den Leiterbahnen 37 und 38 vorteilhaft reduzieren.

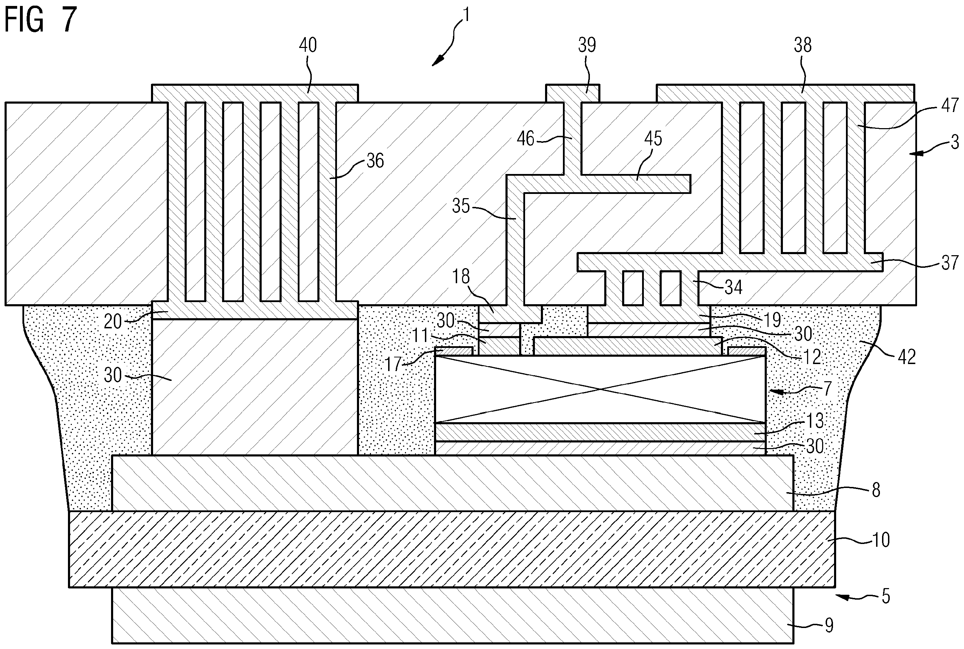

Figur 7 (FIG 7) zeigt eine schematische Schnittdarstellung eines sechsten Ausführungsbeispiels einer Schaltungsanordnung 1. Dieses Ausführungsbeispiel unterscheidet sich von dem in Figur 6 gezeigten Ausführungsbeispiel lediglich dadurch, dass die ersten Durchkontaktierungen 34 nur jeweils bis zu einer im Inneren des ersten Schaltungsträgers 3 verlaufenden Leiterbahn 37 verlaufen, und dass die zweiten Durchkontaktierungen 35 nur jeweils zu einer weiteren im Inneren des ersten Schaltungsträgers 3 verlaufenden Leiterbahn 45 verlaufen, die durch eine weitere Durchkontaktierung 46 (ein weiteres Blind-Via) mit einer zweiten auf der Oberseite des ersten Schaltungsträgers 3 verlaufenden Leiterbahn 39 verbunden ist.

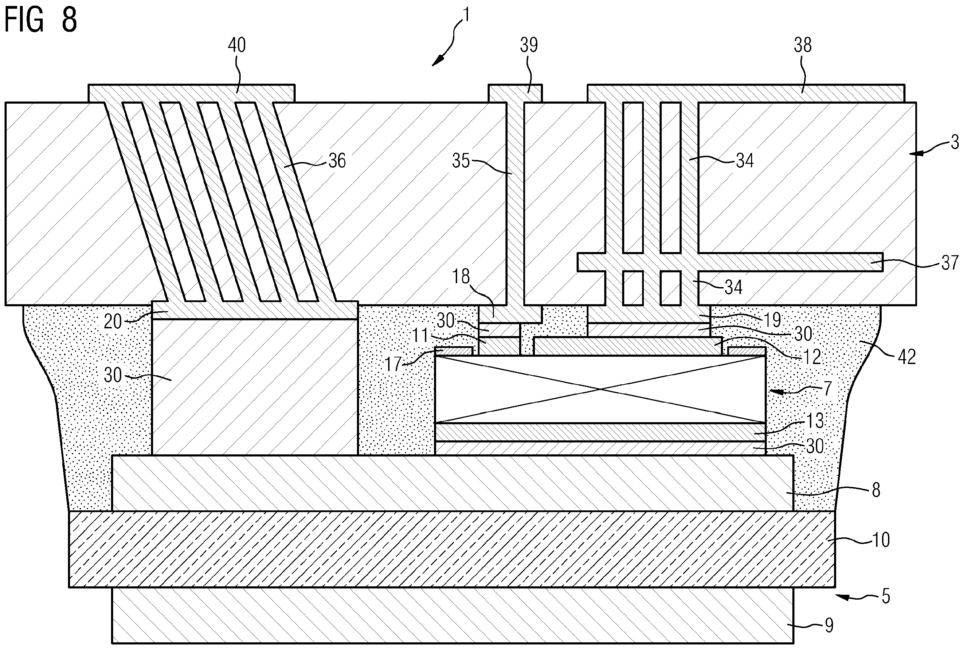

Figur 8 (FIG 8) zeigt eine schematische Schnittdarstellung eines siebten Ausführungsbeispiels einer Schaltungsanordnung 1. Dieses Ausführungsbeispiel unterscheidet sich von dem in Figur 1 gezeigten Ausführungsbeispiel lediglich dadurch, dass die dritten Durchkontaktierungen 36 parallel zu einer Geraden verlaufen, die einen nicht verschwindenden Winkel mit einem Normalenvektor der Unterseite des ersten Schaltungsträgers 3 bildet.

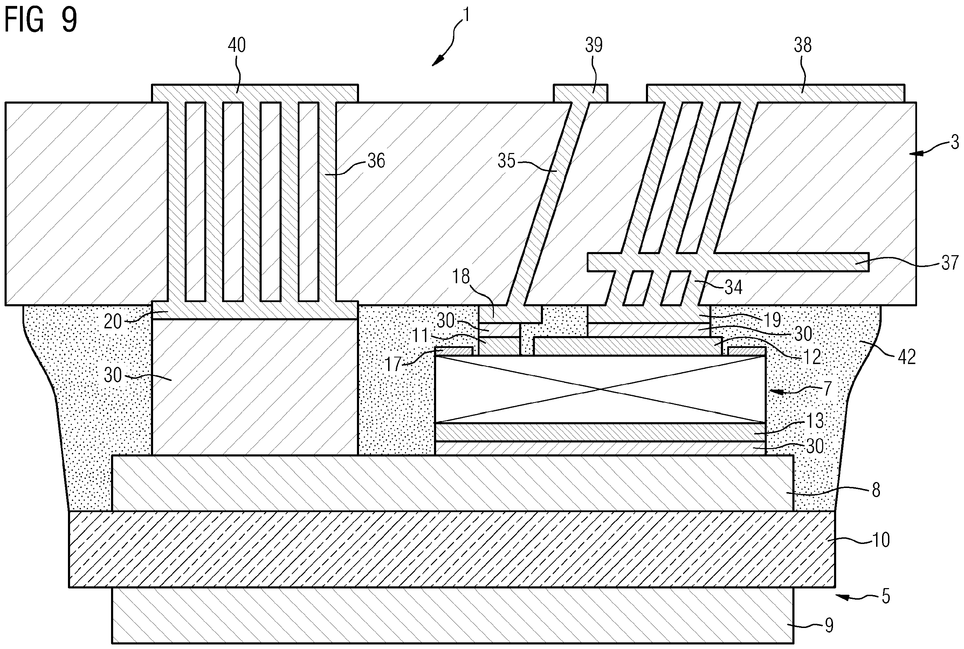

Figur 9 (FIG 9) zeigt eine schematische Schnittdarstellung eines achten Ausführungsbeispiels einer Schaltungsanordnung 1. Dieses Ausführungsbeispiel unterscheidet sich von dem in Figur 1 gezeigten Ausführungsbeispiel lediglich dadurch, dass die ersten Durchkontaktierungen 34 und die zweiten Durchkontaktierungen 35 parallel zu einer Geraden verlaufen, die einen nicht verschwindenden Winkel mit einem Normalenvektor der Unterseite des ersten Schaltungsträgers 3 bildet.

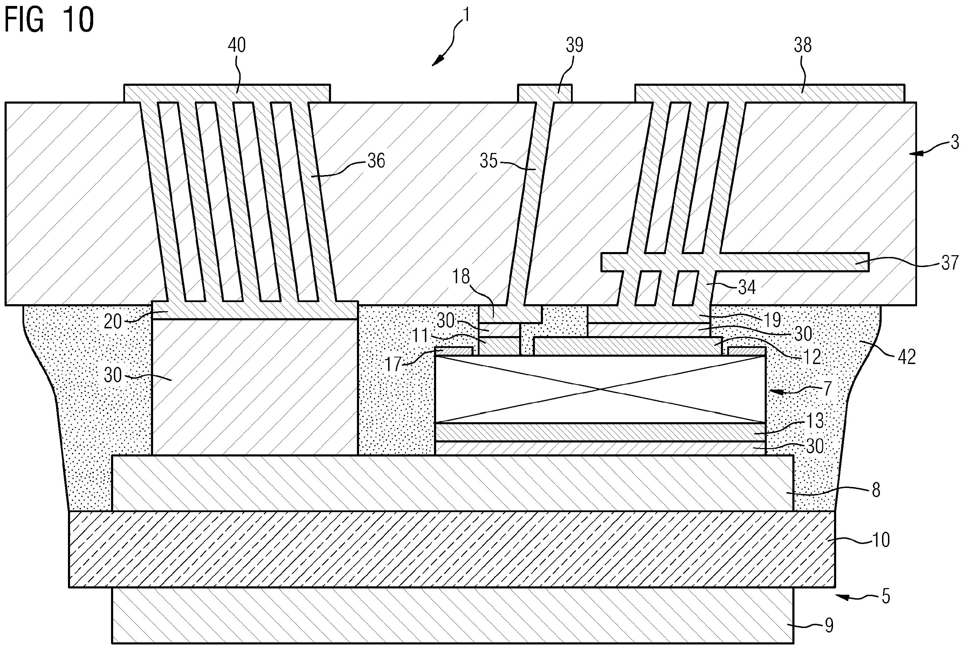

Figur 10 (FIG 10) zeigt eine schematische Schnittdarstellung eines neunten Ausführungsbeispiels einer Schaltungsanordnung 1. Dieses Ausführungsbeispiel unterscheidet sich von dem in Figur 1 gezeigten Ausführungsbeispiel lediglich dadurch, dass die ersten Durchkontaktierungen 34 und die zweiten Durchkontaktierungen 35 parallel zu einer ersten Geraden verlaufen, die einen nicht verschwindenden ersten Winkel mit einem Normalenvektor der Unterseite des ersten Schaltungsträgers 3 bildet, und die dritten Durchkontaktierungen 36 parallel zu einer zweiten Geraden verlaufen, die einen nicht verschwindenden zweiten Winkel mit einem Normalenvektor der Unterseite des ersten Schaltungsträgers 3 bildet.

Bei den in den Figuren 8 bis 10 gezeigten Ausführungsbeispielen sind die Winkel, die Durchkontaktierungen 34, 35, 36 jeweils mit einem Normalenvektor der Unterseite des ersten Schaltungsträgers 3 bilden, derart gewählt, dass ein Abstand jeder dritten Durchkontaktierung 36 von jeder ersten Durchkontaktierung 34 und jeder zweiten Durchkontaktierung 35 in einer zur Unterseite des ersten Schaltungsträgers 3 parallelen Ebene mit dem Abstand dieser Ebene von der Unterseite des ersten Schaltungsträgers 3 zunimmt. Dadurch können vorteilhaft erforderliche Spannungsabstände, Luft- und Kriechstrecken auf der Oberseite des ersten Schaltungsträgers 3 eingehalten werden (beispielsweise Abstände der Leiterbahnen 38, 39 von den Leiterbahnen 40) und die Schaltungsanordnung 1 kann kompaktiert werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung (1), umfassend
- einen mindestens zweilagigen ersten Schaltungsträger (3),
- einen zweiten Schaltungsträger (5) und
- ein zwischen dem ersten Schaltungsträger (3) und dem zweiten Schaltungsträger (5) angeordnetes Halbleiterbauelement (7) mit einem ersten Lastanschluss (12) und einem zweiten Lastanschluss (13), wobei
- der erste Lastanschluss (12) eine dem ersten Schaltungsträger (3) zugewandte erste Lastanschlussfläche (15) aufweist, um die herum eine elektrisch isolierende Randabschlussstruktur (17) angeordnet ist,
- der zweite Lastanschluss (13) eine dem zweiten Schaltungsträger (5) zugewandte zweite Lastanschlussfläche (16) aufweist, die größer als die erste Lastanschlussfläche (15) ist,
- der erste Schaltungsträger (3) auf einer dem Halbleiterbauelement (7) zugewandten Unterseite ein erstes Lastanschlusskontaktpad (19) aufweist, das elektrisch mit der ersten Lastanschlussfläche (15) verbunden ist,
- der erste Schaltungsträger (3) wenigstens eine erste Durchkontaktierung (34) aufweist, die das erste Lastanschlusskontaktpad (19) mit wenigstens einer ersten Leiterbahn (37, 38) verbindet, die im Innern des ersten Schaltungsträgers (3) oder auf einer dem Halbleiterbauelement (7) abgewandten Oberseite des ersten Schaltungsträgers (3) verläuft, und
- der zweite Schaltungsträger (5) eine dem Halbleiterbauelement (7) zugewandte Oberseite aufweist, die von einer ersten elektrisch leitfähigen Schicht (8) gebildet wird, die mit der zweiten Lastanschlussfläche (16) elektrisch verbunden ist.

2. Schaltungsanordnung (1) nach Anspruch 1, wobei das erste Lastanschlusskontaktpad (19) vollständig innerhalb eines Bereiches (41) der Unterseite des ersten Schaltungsträgers (3) angeordnet ist, der zu einem von der Randabschlussstruktur (17) umgebenen Bereich des Halbleiterbauelements (7) korrespondiert.

3. Schaltungsanordnung (1) nach Anspruch 1 oder 2, wobei wenigstens eine erste Durchkontaktierung (34) parallel zu einer ersten Geraden verläuft, die einen nicht verschwindenden Winkel mit einem Normalenvektor der Unterseite des ersten Schaltungsträgers (3) bildet.

4. Schaltungsanordnung (1) nach einem der vorhergehenden Ansprüche, wobei das erste Lastanschlusskontaktpad (19) durch wenigstens eine erste Durchkontaktierung (34) mit wenigstens einer im Innern des ersten Schaltungsträgers (3) verlaufenden ersten Leiterbahn (37) verbunden ist und diese Leiterbahn (37) durch wenigstens eine weitere Durchkontaktierung (47) mit wenigstens einer auf der Oberseite des ersten Schaltungsträgers (3) verlaufenden Leiterbahn (38) verbunden ist.

5. Schaltungsanordnung (1) nach einem der vorhergehenden Ansprüche, wobei das Halbleiterbauelement (7) einen Steueranschluss (11) mit einer dem ersten Schaltungsträger (3) zugewandten Steueranschlussfläche (14) aufweist, die innerhalb des von der Randabschlussstruktur (17) umgebenen Bereichs des Halbleiterbauelements (7) angeordnet ist, und der erste Schaltungsträger (3) auf seiner Unterseite ein Steueranschlusskontaktpad (18) aufweist, das elektrisch mit der Steueranschlussfläche (14) verbunden ist, und der erste Schaltungsträger (3) wenigstens eine zweite Durchkontaktierung (35) aufweist, die das Steueranschlusskontaktpad (18) mit wenigstens einer zweiten Leiterbahn (39, 45) verbindet, die im Innern des ersten Schaltungsträgers (3) oder auf der Oberseite des ersten Schaltungsträgers (3) verläuft.

6. Schaltungsanordnung (1) nach Anspruch 5, wobei das Steueranschlusskontaktpad (18) vollständig innerhalb eines Bereichs (41) der Unterseite des ersten Schaltungsträgers (3) angeordnet ist, der zu einem von der Randabschlussstruktur (17) umgebenen Bereich des Halbleiterbauelements (7) korrespondiert.

7. Schaltungsanordnung (1) nach Anspruch 5 oder 6, wobei das Steueranschlusskontaktpad (18) sich in einen Bereich der Unterseite des ersten Schaltungsträgers (3) hinein erstreckt, der zu der ersten Lastanschlussfläche (15) korrespondiert.

8. Schaltungsanordnung (1) nach Anspruch 7, wobei ein Abschnitt des Steueranschlusskontaktpads (18), der sich in den zu der ersten Lastanschlussfläche (15) korrespondierenden Bereich der Unterseite des ersten Schaltungsträgers (3) hinein erstreckt, zumindest einen nicht kontaktierbaren Bereich (43) aufweist.

9. Schaltungsanordnung (1) nach einem der Ansprüche 5 bis 8, wobei ein zwischen dem Steueranschlusskontaktpad (18) und dem ersten Lastanschlusskontaktpad (19) liegender Bereich der Unterseite des ersten Schaltungsträgers (3) einen nicht kontaktierbaren Bereich (43) aufweist.

10. Schaltungsanordnung (1) nach einem der Ansprüche 5 bis 9, wobei jede zweite Durchkontaktierung (35) parallel zu einer ersten Durchkontaktierung (34) verläuft.

11. Schaltungsanordnung (1) nach einem der vorhergehenden Ansprüche, wobei der zweite Schaltungsträger (5) eine dem Halbleiterbauelement (7) abgewandte Unterseite, die von einer zweiten elektrisch leitfähigen Schicht (9) gebildet wird, und eine zwischen der ersten elektrisch leitfähigen Schicht (8) und der zweiten elektrisch leitfähigen Schicht (9) angeordnete elektrisch isolierende Isolationsschicht (10) aufweist.

12. Schaltungsanordnung (1) nach einem der vorhergehenden Ansprüche, wobei der erste Schaltungsträger (3) auf seiner Unterseite ein zweites Lastanschlusskontaktpad (20) aufweist, das elektrisch mit der ersten elektrisch leitfähigen Schicht (8) des zweiten Schaltungsträgers (5) verbunden ist.

13. Schaltungsanordnung (1) nach Anspruch 12, wobei der erste Schaltungsträger (3) wenigstens eine dritte Durchkontaktierung (36) aufweist, die das zweite Lastanschlusskontaktpad (20) mit wenigstens einer dritten Leiterbahn (40) verbindet, die im Innern des ersten Schaltungsträgers (3) oder auf der Oberseite des ersten Schaltungsträgers (3) verläuft.

14. Schaltungsanordnung (1) nach Anspruch 13, wobei wenigstens eine dritte Durchkontaktierung (36) parallel zu einer zweiten Geraden verläuft, die einen nicht verschwindenden Winkel mit einem Normalenvektor der Unterseite des ersten Schaltungsträgers (3) bildet, so dass ein Abstand dieser dritten Durchkontaktierung (36) von jeder ersten Durchkontaktierung (34) in einer zur Unterseite des ersten Schaltungsträgers (3) parallelen Ebene mit dem Abstand dieser Ebene von der Unterseite des ersten Schaltungsträgers (3) zunimmt.
